Europäisches Patentamt

European Patent Office

Office européen des brevets

(11) Veröffentlichungsnummer: **0 357 632 B1**

# (12) EUROPÄISCHE PATENTSCHRIFT

(45) Veröffentlichungstag der Patentschrift: **22.12.93**

(21) Anmeldenummer: **88903179.5**

(22) Anmeldetag: **15.04.88**

(86) Internationale Anmeldenummer:
**PCT/DE88/00235**

(87) Internationale Veröffentlichungsnummer:
**WO 88/08222 (20.10.88 88/23)**

(51) Int. Cl.⁵: **H03D 3/00**

---

(54) **ANORDNUNG ZUM FILTERN EINES FM-UKW-EMPFANGSSIGNALS.**

---

(30) Priorität: **15.04.87 DE 3712736**
**24.07.87 DE 3724604**

(43) Veröffentlichungstag der Anmeldung:
**14.03.90 Patentblatt 90/11**

(45) Bekanntmachung des Hinweises auf die
Patenterteilung:
**22.12.93 Patentblatt 93/51**

(84) Benannte Vertragsstaaten:
**AT BE CH DE FR GB IT LI NL SE**

(56) Entgegenhaltungen:
**EP-A- 0 048 661        EP-A- 0 075 071**
**WO-A-86/02505        DE-A- 3 147 493**
**FR-A- 2 497 039        GB-A- 0 903 107**

(73) Patentinhaber: **H.U.C. ELEKTRONIK GMBH**
**Gustav-Meyer-Allee 25**
**D-13355 Berlin(DE)**

(72) Erfinder: **HANSEN, Jens**
**Holländer Strasse 37**
**D-1000 Berlin 65(DE)**

(74) Vertreter: **Christiansen, Henning, Dipl.-Ing.**
**Patentanwalt**
**Pacelliallee 43/45**
**D-14195 Berlin (DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft eine Anordnung der im Oberbegriff des Anspruchs 1 angegebenen Art sowie auf einen FM-Empfänger, welcher mit einer derartigen Anordnung versehen ist.

Eine Anordnung dieser Art ist aus der GB-A-903 107 bekannt. Hierin wird ein Empfänger für frequenzmodulierte Signale beschrieben, bei dem eine breit- und eine schmalbandige Filtercharacteristik bzw. deren Überlagerung in einem Zwischenfrequenzfilter vorgesehen ist. Weitere Anordnungen dieser Art sind aus den DE-A-31 47 493 und 34 38 286, der EP-A1-75 071 oder der FR-A-81 21 986 bekannt, welche sämtlich auf den Erfinder zurückgehen.

Bei den heute gebräuchlichen FM-Empfängern für Hörfunk ist ein breitbandiges ZF-Filter vorgesehen. Die Mittenfrequenz $f_{ZF}$ eines derartigen breitbandigen ZF-Filters beträgt bei den meisten Standards 10,7 MHz, während die Kanalbandbreite etwa 200 kHz ($\pm$ 100 kHz symmetrisch zur Mittenfrequenz $f_{ZF}$) ausmacht. Die Durchlaßkurve ist dabei so gewählt, daß ihre Bandbreite etwa der Übertragungsbandbreite entspricht. Infolge der großen Bandbreite werden relativ viele Stör-und Rauschanteile des Antenneneingangssignals von dem bekannten ZF-Filter durchgelassen, was zur Folge hat, daß relativ hohe Eingangsfeldstärken erforderlich sind, um ein empfangswürdiges Nutzsignal (Modulation) zu gewährleisten.

Zur Erhöhung der Empfangsempfindlichkeit ist es aus den oben genannten Druckschriften bekannt, als ZF-Filter ein in Bezug auf die Kanalbandbreite schmalbandiges Filter zu verwenden. Die Mittenfrequenz dieses schmalbandigen ZF-Filter wird in Abhängigkeit von der Modulation des Empfangssignals nachgesteuert. Zu jedem beliebigen Zeitpunkt wird damit exakt dort selektiert, wo sich gerade die Momentan-ZF befindet. Hierdurch ergibt sich eine wesentlich verbesserte Unterdrückung von Stör- und Rauschanteilen. Die Bandbreite dieses gesteuerten ZF-Filters, das auch als "In-Channel-Select"-Filter oder abgekürzt "ICS"-Filter in der Literatur bezeichnet wird, beträgt etwa 20 kHz, wodurch allerdings nur der monofone Nutzsignalanteil (L + R-Komponente des MPX-Nutzsignals) durchgelassen wird.

Aus diesem Grund ist es bei einem Stereo-FM-Empfänger bisher nur möglich, das ICS-Filter parallel zu einem breitbandigen ZF-Filter zu betreiben und wirksam auf die NF-Stufe des Empfängers zu schalten, wenn aufgrund eines zu schwachen oder zu sehr gestörten Empfangssignals (etwa unterhalb 25 μV Antennen-Eingangsspannung) ohnehin nur eine monofone Wiedergabe möglich ist.

Die Aufgabe der Erfindung besteht demgegenüber darin, bei einer Filteranordnung der eingangs erwähnten Art eine Filterung des gesamten - insbesondere MPX- - Signals mit ausreichender Empfindlichkeit ohne wesentlich erhöhten baulichen Aufwand zu erreichen.

Diese Aufgabe wird erfindungsgemäß durch die kennzeichnenden Merkmale des Patentanspruchs 1 gelöst.

Vorteilhafte Ausgestaltungen der erfindungsgemäßen Filteranordnung ergeben sich aus den Unteransprüchen. Hier ist auch ein mit der Filteranordnung ausgerüsteter FM-Stereo-Empfänger in vorteilhafter Weiterbildung angegeben.

Die Erfindung geht zunächst von der Überlegung aus, daß für die Empfindlichkeit in erster Linie eine scharfe Filterabsenkung im unmittelbaren Nahbereich der Momentan-ZF erforderlich ist, um dort einen hohen Störabstand gegenüber Rauschanteilen zu erzielen. Dagegen ist es unerheblich, ob im weiteren Frequenzverlauf der Filterdurchlaßkurve ein flach oder steil abfallender Kurvenast vorliegt.

Anstelle beispielsweise einer Kammfilterstruktur mit diskreten Filterbereichen wird ein zusammenhängender Durchlaßbereich für die beiden L-R-Bänder sowie den ARI/RDS-Hilfsträger des MPX-Signals mit relativ ebenem Frequenzverlauf vorgesehen, welchem um die Mittenfrequenz $f_{ZF}$ ein schmaler, deutlich höherer Filterdurchlaßbereich mit scharfer Filterabsenkung überlagert ist. Letzterer Bereich ist ursächlich für eine hohe Empfindlichkeit. Die Bandbreite dieses schmalen, steilflankigen Filterdurchlaßbereichs beträgt etwa 20 kKz, während die Bandbreite des übrigen Filterdurchlaßbereichs mit relativ ebenem Frequenzverlauf etwa 100 kHz beträgt, womit den an sich gegenläufigen Forderungen nach hoher Empfindlichkeit und hoher Durchlaßbreite für das komplette MPX-Signal Rechnung getragen wird.

Die Vorteile der Erfindung bestehen überraschenderweise aber nicht nur in einer Verbesserung des Übertragungsverhaltens für FM-Stereo-Signale. Es hat sich gezeigt, daß sich durch den gefundenen Verlauf der Übertragungscharakteristik viele Verbesserungen für die Eigenschaften des ICS-Verfahrens allgemein gewinnen lassen. Durch die resonanzartige Überhöhung im Mittenbereich wird eine wesentliche Verbesserung des Signal-Rausch-Verhältnisses erzielt. Die Frequenzbereiche des FM-Signals, welche den größten Anteil innerhalb des Leistungsspektrums haben, werden innerhalb dieses erhöhten Bereichs mit maximaler Amplitude übertragen. Ferner ermöglicht die sich ergebende Flankenform im Bereich des Übergangs vom erhöhten Bereich in die seitlich anschließenden abgeflachteren Bereiche einen linearen Phasengang des Nutzsignals, der zu einer Verringerung der nichtlinearen Verzerrungen beiträgt. Außerdem wird die Hubverträglichkeit heraufgesetzt.

Besonders vorteilhaft bei der Erfindung ist, daß sich durch den gefundenen Frequenzgang die "Nachführbarkeit" der Filter verbessert. Damit ist die Fähigkeit der abstimmbaren ZF-Filter gemeint, der aktuellen Mittenfrequenz der Modulation zu folgen. Hierbei verringern sich insbesondere mögliche "Einschnürungen" der ZF bei hohen Modulationsspannungen, da die Flankensteigungen der Durchlaßcharakteristik insgesamt geringer sind. Damit wird aber auch der Aufwand für die Korrektur des die Filter nachführenden Signals (Phasenmodulation und/oder Filterung) geringer. Zudem verringert sich auch die Gruppenlaufzeit der Nutzsignale, so daß die bei der Filternachführung zu kompensierenden Zeiten kleiner werden. Insgesamt ist zu berücksichtigen, daß die erzielten Verbesserungen in einem Bereich kritischer gestörter Empfangsbedingungen erfolgt, in denen die erzielten Verbesserungen eine wesentliche Heraufsetzung des "Hörgenusses" bedeuten, da erfahrungsgemäß plötzlich einsetzende Störungen einer im übrigen hochwertigen (Musik-)Wiedergabe als besonders beeinträchtigend empfunden werden.

Die Erfindung wird anhand der Zeichnungen näher erläutert. Es zeigen:

Figur 1 eine Durchlaßkurve einer erfindungsgemäßen Filteranordnung,

Figur 2 ein Blockschaltbild eines bevorzugten Ausführungsbeispiels eines FM-Stereo-Empfängers (ohne Vor- und Mischstufen),

Figur 3 Durchlaßkurven der verschiedenen, in Figur 2 vorgesehenen Filterstufen, deren Zusammenschaltung die in Figur 1 gezeigte Durchlaßkurve ergibt;

Figur 4 den Phasengang eines mit der erfindungsgemäßen Filteranordnung innerhalb des Empfängers nach Figur 5 bearbeiteten und demodulierten NF-Signals, und

Figur 5a bis 5d Zeitdiagramme verschiedener Signalverläufe innerhalb einer Stufe zur Erkennung von Nachbarkanalträgern und

Figur 5e ein Blockschaltbild eines Ausführungsbeispiels für eine Stufe zur Erkennung von Nachbarkanalträgern.

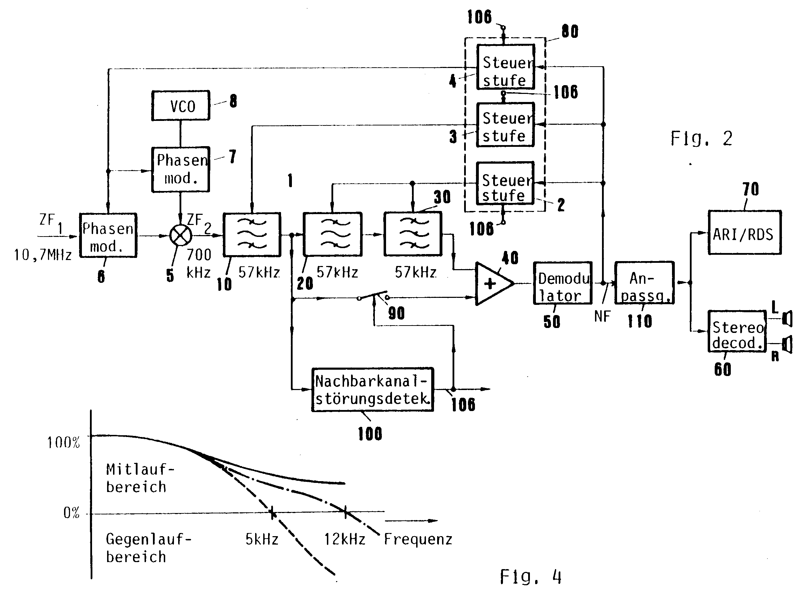

Die Durchlaßkurve gemäß Figur 1, auf die weiter unten näher eingegangen werden wird, betrifft das Durchlaßverhalten des in Figur 2 als Ausführungsbeispiel gezeigten erfindungsgemäßen FM-Stereo-Empfängers. Dieser ist ohne Vorund Mischstufe dargestellt, so daß als Eingangssignal der gezeigten Blockschaltung ein normgerechtes ZF-Signal $ZF_1$ mit einer Frequenz von 10,7 MHz vorliegt.

Wesentlicher Bestandteil der Blockschaltung nach Figur 2 ist die erfindungsgemäße ZF-Filteranordnung 1, welche in einem ersten, oberen Filterzweig drei in Serie angeordnete Filterstufen 10, 20 und 30 aufweist. Entsprechend der Bandbreite des MPX-Signals von 57 kHz weist die Filterstufe 10, welche den relativ ebenen Kurvenabschnitt der Filterdurchlaßkurve gemäß Figur 1 bestimmt und über welche die höherfrequenten Anteile des MPX-Signals gelangen, eine Bandbreite von ±57 kHz, also ungefähr 100 kHz auf. Bei einer günstigen Ausführungsvariante handelt es sich bei dem Filter 10 nicht - wie es in Figur 3 dem durchgezogenen Verlauf des Übertragungsverhaltens (auch der anderen Filter) entspricht - um ein Einzelkreisfilter, sondern um ein zweipoliges Bandfilter. Die Bandbreiten der Filterstufen 20 und 30 sind so bemessen, daß die Bandbreite der Serienschaltung der Filterstufen 10, 20, 30 etwa 20 kHz beträgt.

Bei dem betrachteten MPX-Signal ("MPX" = Multiplex) handelt es sich in erster Linie um ein heute übliches analoges FM-Stereo-Rundfunksignal. Es ist jedoch ohne weiteres möglich, ein digitales FM-Stereo-Rundfunksignal mit Hilfe dieser Filteranordnung zu verarbeiten.

Durch die Serienschaltung der drei Filterstufen 10, 20, 30 ergibt sich der in Figur 1 teilweise gestrichelt angedeutete schmalbandigere Frequenzverlauf $F_{10} + F_{20} + F_{30}$. Die 3-dB-Bandbreite dieser Durchlaßkurve, die mit derjenigen der durchgezogenen Kurve zusammenfällt, beträgt ca. 20% der Übertragungsbandbreite.

Der schmale, steilflankige Verlauf wird dem Verlauf der Durchlaßkurve $F_{10}$ überlagert, woraus sich der in Figur 1 mit durchgezogener Linie gezeichnete Verlauf der unteren Kurve ergibt.

Der in Figur 1 dargestellte durchgezogene Verlauf besteht also aus einem zentralen um die Bandmitte herum resonanzartig überhöhten Bereich. In einer Entfernung von ca. 20 % der gesamten Bandbreite - von der Bandmitte her gesehen (im Falle der FM-Stereo-Übertragung also ca. 20 kHz seitlich der Bandmitte) - , wo die Durchlaßkurve schon um mindestens 6 dB abgefallen ist, geht der steil abfallende Verlauf in einen Bereich über, der weniger steil abfällt. Bis zur (3 dB-)Bandgrenze beträgt der Abfall aber noch mehr als 4 dB.

Diese Überlagerung erfolgt schaltungstechnisch dadurch, daß der Ausgang der ersten Filterstufe 10 in einem zweiten Filterzweig der Filteranordnung 1 einer Addierstufe 40 zugeführt wird, welche ferner mit dem Ausgang der dritten Filterstufe 30 verbunden ist. Bei der Addierstufe 40 handelt es sich zweckmäßigerweise um einen Summierverstärker, welcher das gefilterte ZF-Signal auf den erforderlichen Pegel verstärkt, der für die anschließende Demodulation im Demodulator 50 benötigt wird. Eine in dieser Weise realisierte Filterdurchlaßcharakteristik kann, ohne vom Erfindungsgedanken abzuweichen, auch auf andere Weise, z.B. mittels digitaler Filter schaltungstechnisch verwirklicht werden.

Zwischen dem dargestellten schmalbandigen Verlauf entsprechend der gestrichelten Kontour und dem breitbandigeren durchgezogenen Verlauf wird umgeschaltet in Abhängigkeit vom Ausgangssignal einer Schaltstufe 100, welche ein Maß für die Eigenschaften des empfangenen Signals bildet. Bei dem dargestellten Ausführungsbeispiel ist es eine Nachbarkanalstörungsdetektor, wie er weiter unten näher beschrieben ist.

Das demodulierte, mit "NF" bezeichnete Signal am Ausgang des Demodulators 50 wird mittels einer Korrekturstufe 110 einer Pegel- und ggfs. Phasenkorrektur unterzogen, um die unterschiedlichen Pegel- und Phasenverläufe in den beiden Filterzweigen, sprich: der beiden Eingangssignale der Addierstufe 40, auszugleichen. Das korrigierte NF-Signal, das sämtliche Komponenten des MPX-Signals enthält, wird einem Stereodecoder 60 sowie einer ARI/RDS-Stufe 70 zugeführt.

Der Stereodecoder 60 erzeugt aus den L+R- und L-R-Komponenten die stereofonen Links (L)- und Rechts (R)- Informationen, die entsprechenden L- bzw. R-Kanälen zugeführt werden. Die ARI/RDS-Stufe siebt den modulierten 57 kHz-Hilfsträger des ARI- und/oder RDS-Signals schmalbandig aus, demoduliert und (im Falle von RDS) decodiert das ARI- bzw. RDS-Zusatzsignal und wertet diese Zusatzsignale aus. Die Steuerstufe 80 erzeugt aus dem NF-Signal (=Modulation) am Ausgang des Demodulators 50 ein Mitkopplungs-Steuersignal St, welches den Steuereingängen aller Filterstufen zugeführt wird. Unter ARI-Zusatzsignal wird eine Auto-Radio-Information in Form einer Verkehrsfunksender- und -bereichskennung verstanden, welche in Amplitudenmodulation dem 57 kHz-Hilfsträger aufmoduliert ist. Unter RDS-Zusatzsignal wird eine Radio-Daten-System-Information verstanden, welche zusätzlich oder unabhängig von dem ARI-Zusatzsignal in Form eines digitalen Signals in 2PSK-Modulation dem 57 kHz-Hilfsträger in Quadraturvorlage aufmoduliert ist. Die RDS-Information enthält neben der Verkehrsfunksendererkennung eine Senderidentifikation, eine Programmarterkennung sowie die dasselbe Programm wie der eingestellte Sender ausstrahlenden alternativen Frequenzen (vgl. EBU Doc. Tech. 3244 der Europäischen Rundfunk-Union).

Des weiteren wird das NF-Signal vor oder nach der Korrektur der Steuerstufe 80 Zugeführt, welche in noch näher zu erläuternder Weise die Filterstufen 10, 20 und 30 in Abhängigkeit von der Modulation auf die Momentan-ZF nachsteuert.

Zunächst soll nochmals die unterste Kurve in Fig. 3 betrachtet werden. Die in Fig. 3 mit $F_{10}+F_{20}+F_{30}$ bezeichnete Filterkurve weist im Bereich der auf die Momentan-ZF nachgesteuerten Mittenfrequenz $f_{ZF}$ eine scharfe Filterabsenkung von wenigstens 6 dB bei einer Breite von ca. 20 kHz auf. Diese scharfe Filterabsenkung resultiert, wie schon erwähnt, aus der Hintereinanderschaltung der Filterstufen 10, 20 und 30. Bei einer Überlagerung des Durchlaßbereichs der Summenkurve $F_{10}+F_{20}+F_{30}$ mit dem flachen Durchlaßbereich der Kurve $F_{10}$ in der Addierstufe 4 werden die den Durchlaßbereichen zugeordneten Signalpegel so eingestellt, daß der resultierende Durchlaßbereich der Kurve $2F_{10}+F_{20}+F_{30}$ in seinem Resonanzpunkt etwa 10 dB oberhalb des Durchlaßbereichs der Kurve $F_{10}$ liegt. Damit entstehen relativ eben verlaufende Kurvenäste in einem symmetrisch von der Kanalmitte ($=f_{ZF}$) um etwa 38 kHz entfernten Bereich, welche ausreichend sind für eine wirksame Rausch- und Störunterdrückung des L-R-Bandes im MPX-Signal. Die Durchlaßgrenzen der Gesamtkurve $(F_{10}+F_{20}+F_{30})/F_{10}$ liegen etwa 57 kHz von der Kanalmitte entfernt, so daß auch der 57 kHz-Hilfsträger im MPX-Signal wirksam gefiltert wird.

In dem zweiten Filterzweig der Filteranordnung 1 (Fig. 2) ist ein - bereits erwähnter - elektronischer Schalter 90 vorgesehen, welcher von einer Stufe 100 zur Erkennung von Nachbarkanalstörungen gesteuert wird. Die Stufe 100 wird im dargestellten Beispielsfall vom dem Ausgang der ersten Filterstufe gespeist und weist eine Schaltschwelle auf, oberhalb welcher dem Schalter 90 ein Schaltsignal zugeführt wird. Falls nämlich die Nachbarkanalstörungen einen Grenzwert übersteigen, ist eine Stereowidergabe nicht mehr sinnvoll, so daß über den Schalter 90 die erwähnte Überlagerung der schmalen, steilflankigen Kurve $F_{10}+F_{20}+F_{30}$ (Fig. 3) mit der flachen Kurve $F_{10}$ unterbunden wird und damit nur noch die erwähnte schmale, steilflankige Kurve für die Filterung des ZF-Signals wirksam wird, allerdings nur für eine monofone Signalwidergabe. Das in diesem Fall resultierende ZF-Signal am Ausgang der Addierstufe 40 weist eine höhere Selektivität als im Falle eines geschlossenen Schalters 90 auf, wodurch die detektierten Nachbarkanalstörungen ausgeblendet werden und ein störungsfreier Mono-Empfang gesichert ist.

Die durch den Schalter 90 bewirkte Mono/Stereo-Umschaltung ermöglicht es u.U., auf den heute üblichen Mono-Stereo-Umschalter im Stereodecoder 60 zu verzichten.

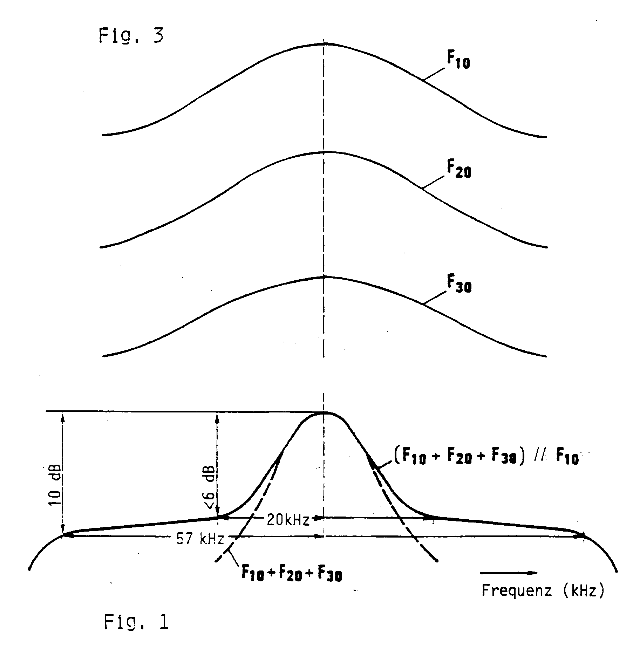

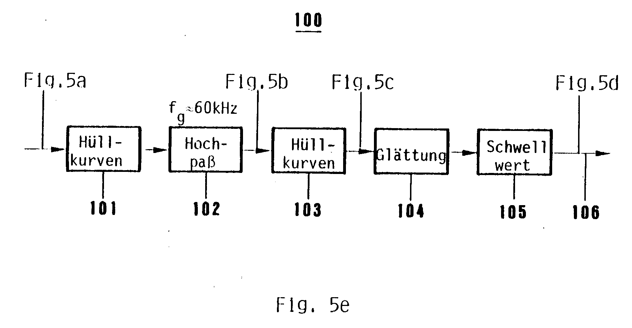

Die in Fig. 5e näher dargestellte Stufe 100 besteht aus der Serienschaltung
- eines ersten Hüllkurvendemodulators 101,
- eines Hochpaßfilters 102 mit einer Großfrequenz von etwa 60 kHz,
- eines zweiten Hüllkurvendemodulators 103;
- einer Glättungsstufe 104, und
- einer Schwellwert-Schaltstufe 105.

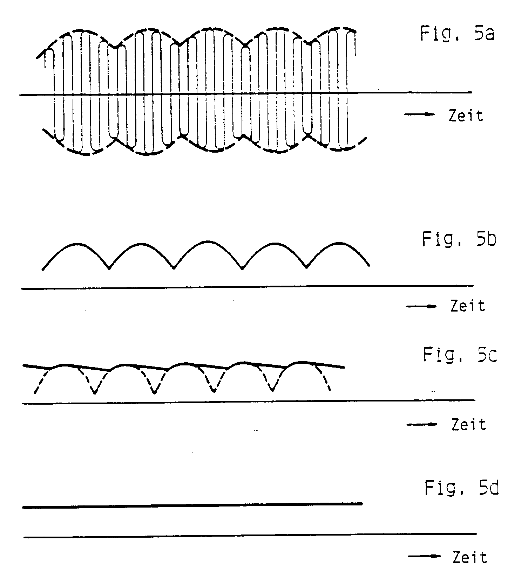

Dem Hüllkurvendemodulator 101 wird das in Fig. 5a veranschaulichte Ausgangssignal der ersten Filterstufe 10 zugeführt, welches durch Interferenzen zwischen Nutz- und Nachbarkanal in der Amplitude moduliert ist. Je stärker der Nachbarkanalträger ist, desto größer ist diese Amplitudenmodulation. Das demodulierte Interferenzsignal (Fig. 5b) am Ausgang des Hüllkurvendemodulators 101 wird mittels eines Hoch- und/oder Tiefpaßfilters 102 von niederfrequenten Signalanteilen, die von der Nutzmodulation herrühren bzw. höherfrequenten Störanteilen befreit. In dem anschließenden zweiten Hüllkurvendemodulator 103 wird über das demodulierte, hochpaßgefilterte Interferenzsignal die Hüllkurve (Fig. 5c) gebildet, welche mittels der Stufe 104 geglättet wird und in der Schwellwert-Schaltstufe 105 mit einem vorgegebenen Referenzpegel verglichen wird. Überschreitet das geglättete Hüllkurvensignal den Referenzpegel, so erzeugt die Schaltstufe 105 an ihrem Ausgang 106 das in Fig. 5d gezeigte Schaltsignal. Dieses Schaltsignal wird, wie in Fig. 4 durch die mit "106" markierten Eingänge der Stufen 2, 3 und 4 angedeutet ist, den Steuerstufen 2, 3 und 4 zugeführt, ferner dem Steuereingang des Schalters 90. In den Steuerstufen 2 und 3 bewirkt das Schaltsigal eine leichte Absenkung der Frequenzanteile der dort gezeigten Steuerspannungen etwa oberhalb 6 kHz. Dagegen bewirkt das Schaltsignal in der Steuerstufe 4 für die Phasenmodulatoren 6, 7 eine leichte Anhebung der Frequenzanteile der dort erzeugten Steuerspannung etwa oberhalb 5 kHz. Diese Frequenzgangbeeinflussungen sind deshalb erforderlich, weil infolge der geänderten Gesamtfiltercharakteristik der gesteuerten ZF-Filterstufen 10, 20, 30 die Phasensteilheit erhöht wird, was ohne die erwähnte Frequenzgangbeeinflussung zu einer erhöhten störphasenmodulation im höheren Frequenzbereich oberhalb etwa 5 kHz führen würde.

Im folgenden soll auf die Nachsteuerung der Filterstufen 10, 20 und 30 näher eingegangen werden. Hierzu sind in Fig. 4 drei verschiedene Phasengänge des NF-Signals am Ausgang des Demodulators gezeigt, wobei mit durchgezogener Linie der erfindungsgemäß erzielte Phasengang angedeutet ist. Infolge der Nachsteuerung der Filterstufen mit dem NF-Signal bzw. einem daraus abgeleiteten Steuersignal tritt ein mit zunehmender NF-Signalfrequenz steigender Phasenwinkel zwischen ZF-Signal und Steuersignal auf. Ohne die nachstehend beschriebenen Maßnahmen würde dieser Phasenwinkel bei etwa 5 kHz so groß werden, daß aus der bis dahin wirksamen Mitkopplung (in Fig. 4 als "Mitlaufbereich" bezeichnet) eine Gegenkopplung ("Gegenlaufbereich") wird.

Da man den erwähnten Phasenwinkel als Phasenmodulation des ZF-Signals verstehen kann, hatte der Erfinder bereits früher die Idee (DE-OS 31 47 493), das ZF-Signal vor der Filterung durch die Filterstufen 10, 20, 30 einer entgegengesetzten Phasenmodulation zu unterwerfen. Hierzu wird, wie aus Fig. 2 ersichtlich ist, in einer ersten Steuerstufe 2 ein nachsteuerndes erstes Steuersignal für die Filterstufen 20 und 30 erzeugt und in einer zweiten Steuerstufe 3 ein zweites Steuersignal für die erste Filterstufe 10 als Phasenmodulator wirksam ist. Mit Hilfe dieser Phasenmodulation läßt sich der in Fig. 4 gestrichelt eingezeichnete Phasengang mit Nullstelle bei 5 kHz in Richtung höherer Frequenzen verschieben (strichpunktiert eingezeichneter Phasengang), so daß sich eine Nullstelle, d.h. ein Wechsel vom erwünschten Mitlaufbereich in den unerwünschten Gegenlaufbereich, bei etwa 12 kHz einstellt, so daß diese Maßnahme noch nicht befriedigen kann.

Bei dem Empfänger nach Fig. 2 sind zwei weitere Phasenmodulatoren 6 und 7 vorgesehen, welche von einer dritten Steuerstufe 4 gemeinsam angesteuert werden. Der Phasenmodulator 6 ist vor einer Mischstufe 5 angeordnet, welche das ankommende Norm-ZF-Signal $ZF_1$ von 10,7 MHz in ein, z weites ZF-Signal $ZF_2$ von z.B. 700 kHz umsetzt. Hierzu dient eine Lokaloszillator 8, dem der dritte Phasenmodulator 7 nachgeschaltet ist. Die Steuersignale der Steuerstufen 2, 3 und 4 sowie die Frequenzgänge der Phasenmodulatoren 8, 7 und 10 sind derart aufeinander abgestimmt, daß sich der in Fig. 4 mit durchgezogener Linie gezeigte Phasengang des NF-Signals am Ausgang des Demodulators 50 ergibt, welcher auch bei höheren NF-Frequenzen im Mitlaufbereich verbleibt. Es hat sich herausgestellt, daß aufgrund der guten mit den erfindungsgemäßen Mitteln erzielten Nachführbarkeit auf bis zu zwei der Phasenmodulatoren verzichtet werden kann, wobei dann bevorzugt ausschließlich der bei der Mischstufe angeordnete Phasenmodulator 6 verbeleiben würde.

Mit Hilfe der Erfindung ist es erstmals und in überraschender Weise möglich, ein MPX-Signal mit erheblich vergrößerter Empfindlichkeit zu empfangen und bis herab auf etwa 8 $\mu$V Antenneneingangsspannung stereofon wiederzugeben. Dabei ist der Filteraufwand nicht größer als bisher für die reine Mono-Lösung.

## Patentansprüche

1. Anordnung zum Filtern eines Zwischenfrequenzsignals in einem FM-Empfänger für frequenzmodulierte Signale, insbesondere für mobilen Empfang, bei welcher die Mittenfrequenz eines bezüglich der Kanalbandbreite relativ schmalbandigen ZF-Filters in Abhängigkeit von der Modulation nachgesteuert wird, **dadurch gekennzeichnet,** daß der Durchlaßbereich des nachgesteuerten ZF-Filters (1) so gewählt ist, daß

   a) in Kanalmitte eine ausgeprägte Resonanz mit einem relativ steilflankigem Abfall um wenigstens 6 dB vorhanden ist;

b) im wesentlichen symmetrisch zur Kanalmitte beidseitig des Resonanzbereichs gelegene Bereiche mit weniger steilem Abfall oder ebenem Verlauf anschließen, und

c) die Durchlaßgrenzen im wesentlichen symmetrisch zur Kanalmitte gelegen sind.

2. Anordnung nach Anspruch 1, **dadurch gekennzeichnet,** daß der steilflankige Abfall im wesentlichen 10 dB und/oder die 3 dB-Bandbreite nur etwa 20% der Kanalbandbreite beträgt.

3. Anordnung nach Anspruch 1, **dadurch gekennzeichnet,** daß der Bereich mit weniger steilem Abfall bzw. der im wesentlichen ebene Verlauf beidseitig der Kanalmitte in einem Abstand von etwa 20% der Kanalbandbreite beginnt.

4. Anordnung nach einem der vorangehenden Ansprüche, **dadurch gekennzeichnet,** daß das nachgesteuerte ZF-Filter (1) wenigstens zwei hintereinander angeordnete Filterstufen (10, 20, 30) aufweist, wobei die Ausgangssignale zweier Filterstufen (10) additiv verknüpfbar sind und das verknüpfte, einen breiteren Frequenzbereich aufweisendes Signal einer nachfolgenden Demodulationsstufe zugeleitet wird.

5. Anordnung nach Anspruch 4, **dadurch gekennzeichnet,** daß es sich bei mindestens einer der Filterstufen, deren Ausgangsignal additiv verknüpfbar ist, um ein Bandfilter mit relativ breiter Durchlaßcharakteristik handelt.

6. Anordnung nach Anspruch 4, **dadurch gekennzeichnet,** daß es sich bei mindestens einer der Filterstufen, deren Ausgangssignal additiv verknüpfbar ist, um ein Einzelkreisfilter mit relativ schmaler Durchlaßcharakteristik handelt.

7. Anordnung nach Anspruch 6, **dadurch gekennzeichnet,** daß zwei hintereinandergeschaltete, auf die gleiche Frequenz abgestimmte Einzelkreisfilter vorgesehen sind.

8. Anordnung nach Anspruch 4, **dadurch gekennzeichnet,** daß die additive Verknüpfung des Ausgangssignals der ersten Stufe (10) durch Steuerung einer Schaltung erfolgt, deren Ausgangssignal ein Maß für die Empfangsqualität bildet, wobei unterhalb eines Grenzwertes des ein Maß für die Empfangsqualität bildenden Signals die additive Verknüpfung unterbleibt.

9. Anordnung nach Anspruch 8, **dadurch gekennzeichnet,** daß die Schaltung, deren Ausgangssignal ein Maß für die Empfangsqualität bildet, durch eine Schaltung für die Nachbarkanalerkennung gebildet wird.

10. Anordnung nach Anspruch 8, **dadurch gekennzeichnet,** daß die Schaltung zur Nachbarkanalerkennung eine Serienschaltung aus folgenden Baustufen aufweist:

- einen erster Hüllkurvendemodulator (101), welchem das durch Interferenzen zwischen Nutz- und Nachbarkanal in der Amplitude modulierte Ausgangssignal der ersten Filterstufe (10) zugeführt wird;
- ein Hoch- und/oder Tiefpaßfilter (102), welches das demodulierte Interferenzsignal am Ausgang des ersten Hüllkurvendemodulators (101) von hoch- oder niederfrequenten Signalanteilen trennt;
- einen zweiten Hüllkurvendemodulator (103), welcher über das demodulierte, hochpaßgefilterte Interferenzsignal die Hüllkurve bildet, deren Pegel ein Maß für den Pegel des Nachbarkanalträgers darstellt, und
- eine Schwellwert-Schaltstufe (105), welche das gegebenenfalls geglättete (Glättungsstufe 104) Hüllkurvensignal mit einem vorgegebenen Referenzpegel vergleicht und bei Überschreiten des Referenzpegels ein Schaltsignal abgibt.

11. FM-Empfänger mit einer als ZF-Filter vorgesehenen Anordnung gemäß Anspruch 1, einem dem ZF-Filter nachgeschalteten Demodulator, **dadurch gekennzeichnet,** daß nach dem Demodulator (50) eine Korrekturstufe (110) angeordnet ist, die so ausgebildet ist, daß das die durch unterschiedliche Gruppenlaufzeiten und Pegel der additiv verknüpften Filterstufen entstehenden unterschiedlichen Phasenverläufe und Pegel in dem Niederfrequenzbereich ausgeglichen werden.

12. FM-Empfänger nach Anspruch 11, **dadurch gekennzeichnet,** daß

- die Steuerspannung (Steuerstufen 2, 3) für die nachgesteuerten ZF-Filterstufen (10, 20, 30) im Frequenzgang derart beeinflußt wird, daß die Frequenzanteile etwa oberhalb 6 kHz leicht abgesenkt werden, und

- die Steuerspannung des zweiten und dritten Phasenmodulators (6, 7) im Frequenzgang derart beeinflußt wird, daß die hohen Frequenzanteile etwa ab 5 kHz leicht angehoben werden.

13. FM-Empfänger nach Anspruch 10, **dadurch gekennzeichnet,** daß zur Nachbarkanalerkennung eine Serienschaltung aus folgenden Baustufen vorgesehen ist:
- ein erster Hüllkurvendemodulator (101), welchem das durch Interferenzen zwischen Nutz- und Nachbarkanal in der Amplitude modulierte Ausgangssignal der ersten Filterstufe (10) zugeführt wird;
- ein Hoch- und/oder Tiefpaßfilter (102), welches das demodulierte Interferenzsignal am Ausgang des ersten Hüllkurvendemodulators (101) von hoch- oder niederfrequenten Signalanteilen trennt;
- ein zweiter Hüllkurvendemodulator (103), welcher über das demodulierte, hochpaßgefilterte Interferenzsignal die Hüllkurve bildet, deren Pegel ein Maß für den Pegel des Nachbarkanalträgers darstellt, und
- eine Schwellwert-Schaltstufe (105), welche das gegebenenfalls geglättete (Glättungsstufe 104) Hüllkurvensignal mit einem vorgegebenen Referenzpegel vergleicht und bei Überschreiten des Referenzpegels ein Schaltsignal abgibt.

**Claims**

1. An arrangement for filtering an intermediate frequency signal in an FM receiver for frequency modulated signals, particularly for mobile reception, wherein the centre frequency of a comparatively narrow-band intermediate frequency filter relative to the band width of the channel is tracked dependent on the modulation,
characterised in that the band pass range of the tracked intermediate frequency filter (1) is selected so that
(a) there is a pronounced resonance in the centre of the channel with a relative steep-sided drop of at least 6 dB;
(b) substantially symmetrically with the centre of the channel there are adjoining ranges on both sides of the resonance range, with a less steep drop or a flat shape, and
(c) the band pass limits are substantially symmetrical with the centre of the channel.

2. An arrangement according to claim 1, characterised in that the steep-sided drop is substantially 10 dB and/or the 3 dB band width is only about 20% of the band width of the channel.

3. An arrangement according to claim 1, characterised in that the range with a less steep drop or the substantially flat shape begins on both sides of the centre of the channel, at a distance of about 20% of the band width of the channel.

4. An arrangement according to any of the preceding claims, characterised in that the tracked intermediate frequency filter (1) has at least two filter stages (10, 20, 30) in series, the output signals of two filter stages (10) being combined additively, and the combined signal which has a wider frequency range being passed to a downstream demodulation stage.

5. An arrangement according to claim 4, characterized in that at least one of the filter stages, the output signals of which can be combined additively, is a band filter with relatively broad band pass characteristics.

6. An arrangement according to claim 4, characterized in that at least one of the filter stages, the output signals of which can be combined additively, is a one-circuit filter with relatively narrow band pass characteristics.

7. An arrangement according to claim 6, characterized in that two one-circuit filters are provided, connected in series and tuned to the same frequency.

8. An arrangement according to claim 4, characterized in that the additive combination of the output signal of the first stage (10) is effected by controlling a circuit, the output signal of which forms a measure of the quality of reception, there being no additive combination below a limit value of the signal forming a measure of the quality of reception.

9. An arrangement according to claim 8, characterized in that the circuit of which the output signal forms a measure of the quality of reception is formed by a circuit for adjacent channel recognition.

10. An arrangement according to claim 3, characterized in that the channel for adjacent channel recognition has a series connection of the following component stages:
- a first envelope demodulator (101), to which is supplied the output signal of the first filter stage (10) amplitude modulated by interference between the useful channel and the adjacent channel;

- a high and/or low pass filter (102) which separates the demodulated interference signal at the output of the first envelope demodulator (101) from high or low frequency components of the signal;
- a second envelope demodulator (103) which, by means of the demodulated, high pass filtered interference signal, forms the envelope, the level of which is a measure of the level of the adjacent channel carrier, and
- a threshold value switching stage (105) which compares the possibly smoothed (smoothing stage 104) envelope signal with a predetermined reference level and emits a switching signal when the reference level is exceeded.

11. An FM receiver with an arrangement according to claim 1 provided as an intermediate frequency filter, a demodulator downstream of the intermediate frequency filter, characterized in that a correction stage (110) is arranged downstream of the demodulator (50) and is constructed so that the different phase patterns and levels caused by different group delays and levels of the additively combined filter stages are equalized in the low frequency range.

12. An FM receiver according to claim 11, characterized in that
- the control voltage (control stages 2, 3) for the tracked intermediate frequency filter stages (10, 20, 30) are affected in their frequency response in such a way that the frequency components above about 6 kHz are slightly lowered, and
- the control voltage of the second and third phase modulators (6, 7) are affected in their frequency response in such a way that the high frequency components from about 5 kHz are slightly raised.

13. An FM receiver according to claim 10, characterized in that a series connection of the following component stages is provided for adjacent channel recognition:
- a first envelope demodulator (101), to which is supplied the output signal of the first filter stage (10) amplitude modulated by interference between the useful channel and the adjacent channel;
- a high and/or low pass filter (102) which separates the demodulated interference signal at the output of the first envelope demodulator (101) from the high or low frequency components of the signal;

- a second envelope demodulator (103) which forms the envelope, the level of which is a measure of the level of the adjacent channel carrier, by means of the demodulated, high pass filtered interference signal, and
- a threshold value switching stage (105), which compares the possibly smoothed (smoothing stage 104) envelope signal with a predetermined reference level and emits a switching signal when the reference level is exceeded.

## Revendications

1. Agencement de filtrage d'un signal de fréquence intermédiaire (FI) dans un récepteur à modulation de fréquence pour signaux modulés en fréquence, en particulier pour la réception mobile, dans lequel la fréquence médiane d'un filtre de fréquence intermédiaire à bande relativement étroite par rapport à la largeur de bande du canal est réajustée en fonction de la modulation, caractérisé en ce que la bande passante du filtre FI réajusté est choisie de telle sorte que
   a) une résonance prononcée avec une chute à front relativement raide d'environ au moins 6 dB est présente au milieu du canal;
   b) des gammes sensiblement symétriques au milieu du canal, suivent de chaque côté de la gamme de résonance avec une chute moins raide ou une allure plane, et
   c) les limites de passage sont situées sensiblement symétriquement par rapport au milieu du canal.

2. Agencement selon la revendication 1, caractérisé en ce que la chute à front raide est sensiblement de 10 dB et/ou en ce que la largeur de bande de 3 dB ne représente pratiquement que 20% de la largeur de bande du canal.

3. Agencement selon la revendication 1, caractérisé en ce que la gamme dont la chute est moins raide ou dont l'allure est sensiblement plane commence de chaque côté du milieu du canal à une distance d'environ 20% de la largeur de bande du canal.

4. Agencement selon l'une des revendications précédentes, caractérisé en ce que le filtre FI réajusté (1) présente au moins deux étages de filtre disposés l'un derrière l'autre (10, 20, 30), les signaux de sortie de deux étages de filtre (10) pouvant être enchaînés de manière additive et le signal enchaîné qui présente une gamme de fréquence plus large étant amené à un étage de démodulation consécutif.

5. Agencement selon la revendication 4, caractérisé en ce qu'au moins un des étages de filtre, dont le signal de sortie peut être enchaîné de manière additive, est un filtre de bande à caractéristique passante relativement large.

6. Agencement selon la revendication 4, caractérisé en ce que qu'au moins un des étages de filtre, dont le signal de sortie peut être enchaîné de manière additive, est un circuit filtre unique à caractéristique de bande passante relativement étroite.

7. Agencement selon la revendication 6, caractérisé en ce qu'il est prévu deux filtres à circuit unique montés en série et réglés sur la même fréquence.

8. Agencement selon la revendication 4, caractérisé en ce que l'enchaînement additif du signal de sortie du premier étage (10) se produit par la commande d'un circuit dont le signal de sortie forme une grandeur pour la qualité de réception, l'enchaînement additif restant au-dessous d'une valeur limite du signal formant une grandeur pour la qualité de réception.

9. Agencement selon la revendication 8, caractérisé en ce le circuit, dont le signal de sortie forme une grandeur pour la qualité de réception, est formé par un circuit pour la reconnaissance du canal voisin.

10. Agencement selon la revendication 8, caractérisé en ce que le circuit de reconnaissance du canal voisin comporte un circuit en série présentant composants suivants:
    - un premier démodulateur de courbe enveloppe (10) auquel est fourni le signal de sortie du premier étage de filtre (10), modulé en amplitude par des interférences entre le canal utile et le canal voisin;
    - un filtre passe haut et/ou un filtre passe-bas (102) qui sépare le signal d'interférence démodulé à la sortie du premier démodulateur de courbe enveloppe (101) par rapport aux composantes de signal à haute ou basse fréquence ;
    - un second démodulateur de courbe enveloppe (103) qui forme par l'intermédiaire du signal d'interférence démodulé et filtré passe haut, la courbe enveloppe dont le niveau représente une grandeur pour le niveau de la porteuse du canal voisin, et

    - un étage de commutation à seuil (105) qui compare le signal de courbe enveloppe, le cas échéant lissé, (étage de lissage 104) avec un niveau de référence donné et fournit un signal de commutation en cas de dépassement du niveau de référence.

11. Récepteur à modulation de fréquence avec un agencement prévu comme filtre FI selon la revendication 1, avec un démodulateur placé en aval du filtre FI, caractérisé en ce qu'un étage de correction (110) est disposé après le démodulateur (50), l'étage de correction étant réalisé de telle sorte que les évolutions de phase et les niveaux dûs aux temps de propagation de groupe et aux niveaux différents des étages de filtres à enchaînement additif sont compensés dans la gamme de basse fréquence.

12. Récepteur à modulation de fréquence selon la revendication 11, caractérisé en ce que
    - la tension de commande (étages de commande 2, 3) pour les étages de filtre de FI réajustés (10, 20, 30) est influencée dans la réponse en fréquence de telle sorte que les composantes de fréquence environ sensiblement au-dessus de 6 kHz peuvent être facilement abaissées, et
    - la tension de commande des second et troisième modulateurs de phase (6, 7) est influencée dans la réponse en fréquence de telle sorte que les composantes de fréquence élevée sensiblement environ à partir de 5 kHz sont légèrement augmentées.

13. Récepteur à modulation de fréquence selon la revendication 10, caractérisé en ce qu'il est prévu pour la reconnaissance du canal voisin une commutation en série constituée des composants suivants :
    - un premier démodulateur de courbe enveloppe (10) auquel est fourni le signal de sortie du premier étage de filtre (10), modulé en amplitude par des interférences entre le canal utile et le canal voisin;
    - un filtre passe haut et/ou un filtre passe-bas (102) qui sépare le signal d'interférence démodulé à la sortie du premier démodulateur de courbe enveloppe (101) par rapport aux composants de signal à haute ou basse fréquence ;
    - un second démodulateur de courbe enveloppe (103) qui forme par l'intermédiaire du signal d'interférence démodulé et filtré passe-haut, la courbe enveloppe dont le niveau représente une grandeur pour le niveau de la porteuse du canal voisin, et

- un étage de commutation à seuil (105) qui compare le signal de courbe enveloppe, le cas échéant lissé, (étage de lissage 104) avec un niveau de référence donné et fournit un signal de commutation en cas de dépassement du niveau de référence.

10

EP 0 357 632 B1

**Fig. 2**

106  80

Steuer stufe  4  106

Steuer stufe  3

VCO  8

Steuer stufe  2  106

Phasen mod.  7

70

ARI/RDS

1  30

$ZF_1$

Phasen mod.  $ZF_2$  57kHz  57kHz  57kHz  40

10,7MHz  6  5  700 kHz  10  20  Demodu lator  An- passg.  50  NF  110

90  Stereo decod.  L  R

Nachbarkanal- störungsdetek.  106  60

100

100%

Mitlauf- bereich

0%

Gegenlauf- bereich  5kHz  12kHz  Frequenz

**Fig. 4**

Fig. 3

$F_{10}$

$F_{20}$

$F_{30}$

$(F_{10} + F_{20} + F_{30})$ // $F_{10}$

10 dB

<6 dB

20kHz

57 kHz

$F_{10} + F_{20} + F_{30}$

Frequenz (kHz)

Fig. 1

Fig. 5e

| 101 | 102 | 103 | 104 | 105 | 106 |
|-----|-----|-----|-----|-----|-----|

Hüllkurven
$f_g \approx 60 kHz$
Hochpaß
Hüllkurven
Glättung
Schwell
wert

Fig.5a          Fig.5b          Fig.5c          Fig.5d

$\overline{100}$

Fig. 5a

Fig. 5b

Fig. 5c

Fig. 5d